# EUROPÄISCHE PATENTSCHRIFT

(11) **EP 3 262 666 B1**
(45) Veröffentlichungstag und Bekanntmachung des Hinweises auf die Patenterteilung: **24.02.2021**
(21) Anmeldenummer: 15816184.4
(22) Anmeldetag: 21.12.2015
(51) Int. Cl.: H01G 4/232, H01G 2/06, H01G 4/38, H05K 1/18, H05K 3/34

(54) **ELEKTRISCHES BAUELEMENT UND VERFAHREN ZUR HERSTELLUNG EINES ELEKTRISCHEN BAUELEMENTS**
ELECTRICAL ELEMENT AND METHOD FOR MANUFACTURING IT
COMPOSANT ÉLECTRIQUE ET PROCÉDÉ DE MANUFACTURE DE CE COMPOSANT

(30) Priorität: 27.02.2015 DE 102015102866
(43) Veröffentlichungstag der Anmeldung: 03.01.2018
(73) Patentinhaber: TDK Electronics AG, 81671 München (DE)
(72) Erfinder: KOINI, Markus, 8054 Seiersberg (AT); KONRAD, Jürgen, 8054 Graz (AT); RINNER, Franz, 8523 Frauental an der Lassnitz (AT); PUFF, Markus, 8010 Graz (AT); STADLOBER, Monika, 8055 Graz (AT); KÜGERL, Georg, 8552 Eibiswald (AT); WIPPEL, Thomas, 8510 Stainz (AT)
(74) Vertreter: Epping - Hermann - Fischer
(86) Internationale Anmeldenummer: PCT/EP2015/080853
(87) Internationale Veröffentlichungsnummer: WO 2016/134804

(56) Entgegenhaltungen:
- DE-A1- 19 928 190
- DE-A1-102013 109 093
- US-A1- 2009 147 440
- US-A1- 2013 146 347
- US-A1- 2014 160 624
- US-B1- 6 346 127
- US-B1- 6 924 967
- US-B1- 7 331 799

## Beschreibung

Es wird ein elektrisches Bauelement angegeben. Insbesondere handelt es sich um ein keramisches Bauelement. Das Bauelement ist beispielsweise als Kondensator ausgebildet. Weiterhin wird ein Verfahren zur Herstellung eines elektrischen Bauelements angegeben.

Bei einem elektrischen Bauelement als Commodity-Produkt werden je nach Einbaugebiet unterschiedliche Anforderungen an die Größe sowie die Aufbau- und Verbindungstechnik gestellt. Dies führt oftmals zu notwendigen Anpassungen des Produktes und bedingt die Herstellung von Spezial-Typen einer Bauform.

Bekannt sind beispielsweise oberflächenmontierbare Keramikchips mit Kappenmetallisierung, wie sie beispielsweise in der Druckschrift EP 0 929 087 A2 beschrieben sind. Bei diesen Bauelementen werden Leadframes zur Verbesserung der mechanischen Stabilität verwendet. Andere Kondensatoren sind beispielsweise mit Lötpins ausgestattet. Die Bauelemente sind allerdings jeweils in ihrem Backend (Verbindungstechnik) festgelegt. Für einen spezifischen Kondensatortyp ist das Backend oftmals durch den Einsatztemperaturbereich und die mechanische Festigkeit festgelegt.

Die US 7 331 799 B1, US 2013/0146347 A1 und die US 2009/147440 A1 beschreiben Kondensatoren aufweisend mehrere Teilkörper.

Die US 6 346 127 B1 beschreibt ein Verfahren zur Herstellung eines Kondensators, bei dem mehrere Kondensatorelemente auf einer Metallisierung auf einer Schicht angeordnet werden, wobei bei einer Separierung der Kondensatorelemente die Metallisierung durchtrennt wird.

Es ist eine Aufgabe der vorliegenden Erfindung ein elektrisches Bauelement mit verbesserten Eigenschaften anzugeben. Ein elektrisches Bauelement gemäß der Erfindung ist mit den Merkmalen des Anspruchs 1 definiert, eine Bauelementanordnung gemäß der Erfindung ist mit den Merkmalen des Anspruchs 10 definiert, ein Verfahren zur Herstellung eines Bauelements gemäß der Erfindung ist mit den Merkmalen des Anspruchs 11 definiert.

Gemäß einem ersten Aspekt der vorliegenden Erfindung wird ein elektrisches Bauelement aufweisend mehrere Teilkörper angegeben. Das Bauelement weist einen Sockel auf, auf dem die Teilkörper angeordnet sind.

Erfindungsgemäß weist das Bauelement zwei Anschlusskontakte zum elektrischen Anschluss der Teilkörper an einen Träger auf. Die Anschlusskontakte sind an gegenüberliegenden Seiten der Teilkörper angeordnet. Die in Bezug auf einen Anschlusskontakt beschriebenen Eigenschaften gelten vorzugsweise entsprechend für den anderen Anschlusskontakt. Der Sockel ist vorzugsweise mit beiden Anschlusskontakten verbunden.

Beispielsweise handelt es sich bei dem Bauelement um einen Kondensator, insbesondere um einen Leistungskondensator. Bei den Teilkörpern handelt es sich vorzugsweise um keramische Körper. Die Teilkörper weisen vorzugsweise jeweils einen Vielschichtaufbau auf. Beispielsweise weisen die Teilkörper jeweils übereinander angeordnete keramische Schichten und Elektrodenschichten auf. Die Schichten eines Teilkörpers sind vorzugsweise gemeinsam gesintert.

Die Teilkörper sind beispielsweise nebeneinander auf dem Sockel angeordnet. Vorzugsweise weisen die Teilkörper alle die gleichen Abmessungen auf. Die Teilkörper bilden vorzugsweise keinen monolithischen Sinterkörper. Beispielsweise werden bei der Herstellung des Bauelements die Teilkörper jeweils in gesinterter Form bereitgestellt und anschließend nebeneinander angeordnet. In einer Ausführungsform sind die Teilkörper nicht aneinander befestigt. Benachbarte Teilkörper können in einem Abstand voneinander angeordnet sein. Die Teilkörper werden in ihrer Gesamtheit auch als Grundkörper des Bauelements bezeichnet.

Das Bauelement ist vorzugsweise als Modul derart ausgebildet, dass die Anzahl der Teilkörper je nach den gewünschten Eigenschaften des Bauelements gewählt werden kann, ohne dass eine aufwändige Umkonstruktion des Bauelements erforderlich ist. Weiterhin ermöglicht der Aufbau des Grundkörpers aus separaten Teilkörpern den Ausgleich von Fertigungstoleranzen. Zudem kann insbesondere bei Verwendung eines piezoelektrischen Materials ein Aufbau mechanischer Spannungen im Bauelement verhindert werden.

Der Sockel weist vorzugsweise ein nicht-leitfähiges Material, beispielsweise ein Kunststoffmaterial, auf. Der Sockel dient zur Gewährleistung einer ausreichenden mechanischen Stabilität des Bauelements. Der Sockel ist vorzugsweise einteilig ausgebildet.

In einer Ausführungsform sind die Teilkörper nicht am Sockel befestigt. Dies ermöglicht eine besonders große Flexibilität bei der Herstellung des Bauelements. Die Teilkörper können jedoch zur Erhöhung der mechanischen Stabilität auch am Sockel befestigt sein, beispielsweise auf den Sockel aufgeklebt sein.

Der Anschlusskontakt dient vorzugsweise zur Zuführung elektrischer Spannung und elektrischer Signale zum Bauelement. Durch den Anschlusskontakt wird vorzugsweise eine parallele elektrische Verschaltung der Teilkörper hergestellt. Der Träger weist vorzugsweise wenigstens einen elektrischen Kontakt auf, mit dem der Anschlusskontakt elektrisch verbunden wird. Der Träger ist insbesondere als Leiterplatte ausgebildet. Weiterhin kann der Anschlusskontakt auch zur Herstellung einer mechanischen Befestigung und einer thermischen Verbindung zum Träger dienen.

Der Anschlusskontakt ist beispielsweise aus einem Blech gebildet. Dabei wird beispielsweise aus einem planaren Blech zuerst ein planares Stück mit den Abmessungen des Anschlusskontakts, beispielsweise durch Ausstanzen, gebildet. Anschließend wird der Anschlusskontakt vorzugsweise in eine gebogene Form gebracht. Beispielsweise weist der Anschlusskontakt eine gewinkelte Form auf. Es kann sich beim Anschlusskontakt auch um einen Leadframe handeln.

In einer Ausführungsform ist der Anschlusskontakt durch den Sockel hindurchgeführt. Dies ermöglicht eine besonders stabile Verbindung des Anschlusskontaktes mit dem Sockel. Alternativ kann der Anschlusskontakt auch um den Sockel herumgeführt sein.

Die Teilkörper sind vorzugsweise zwischen zwei Anschlusskontakten eingeklemmt. Beispielsweise sind die Anschlusskontakte federnd ausgebildet, so dass bei der Assemblierung des Bauelements die Anschlusskontakte auseinandergedrückt und die Teilkörper dann zwischen den Anschlusskontakten angeordnet werden. Alternativ oder zusätzlich dazu kann der Sockel federnd ausgebildet sein.

Der Anschlusskontakt weist vorzugsweise wenigstens einen Kontaktbereich zur Befestigung des Anschlusskontakts am Grundkörper, insbesondere den Teilkörpern, des Bauelements auf. Weiterhin weist der Anschlusskontakt vorzugsweise wenigstens einen Anschlussbereich zur Befestigung am Träger auf. Beispielsweise befindet sich der Anschlussbereich auf einer Seite, insbesondere einer Oberseite, des Sockels und der Kontaktbereich auf der gegenüberliegenden Seite, insbesondere einer Unterseite, des Sockels.

In einer Ausführungsform sind die Teilkörper zusätzlich oder alternativ zur Klemmung durch ein Kontaktmittel am Anschlusskontakt befestigt. Als Kontaktmittel kann beispielsweise ein Lot- oder Sintermaterial verwendet werden. Die Teilkörper weisen beispielsweise jeweils einen Außenkontakt auf, an dem der Anschlusskontakt befestigt ist. Der Außenkontakt ist beispielsweise als Metallschicht, insbesondere als gesputterte Metallschicht, ausgebildet.

Erfindungsgemäß weist der Anschlusskontakt, insbesondere in seinem Kontaktbereich, mehrere Teilkontakte auf, wobei jeder Teilkontakt einen der Teilkörper kontaktiert. Die Teilkontakte sind beispielsweise als Kontaktfinger ausgebildet. Vorzugsweise sind die Teilkontakte in einem Verbindungsbereich miteinander verbunden. Der Verbindungsbereich befindet sich beispielsweise nur in Sockelnähe und/oder innerhalb des Sockels.

Durch eine derartige Ausbildung von Teilkontakten ist vorzugsweise eine Separierbarkeit des Bauelements ermöglicht, so dass bei Durchtrennung des Bauelements entlang einer Ebene zwischen zwei Teilkörpern weiterhin jeder Teilkörper durch einen Teilkontakt kontaktiert ist. Durch das Vorhandensein des Verbindungsbereichs nur in Sockelnähe kann eine mechanische Flexibilität des Anschlusskontakts erreicht werden. Dies ermöglicht eine einfache Assemblierung des Bauelements sowie einen Ausgleich mechanischer Spannungen. Beispielsweise ist der Anschlusskontakt zur SMD-, d.h., Oberflächen-Montage ausgebildet. Alternativ kann der Anschlusskontakt auch zur Pin-Montage ausgebildet sein. Beispielsweise kann die Pin-Montage durch Lötung oder durch Einpressung erfolgen. Vorzugsweise kann die Montageform des Anschlusskontakts flexibel gewählt werden, ohne dass das Bauelement in seiner Form oder seinem Aufbau geändert werden muss.

Vorzugsweise weist der Anschlusskontakt, insbesondere in seinem Anschlussbereich, mehrere Teilanschlüsse zur elektrischen Verbindung mit dem Träger auf. Je nach der gewünschten Montageart sind die Teilanschlüsse beispielsweise in Form von Laschen oder Pins ausgebildet. Die Teilanschlüsse sind beispielsweise nur in einem Verbindungsbereich in der Nähe oder innerhalb des Sockels miteinander verbunden.

Durch eine derartige Ausbildung von Teilanschlüssen ist vorzugsweise eine Separierbarkeit des Bauelements ermöglicht, so dass bei Durchtrennung des Bauelements entlang einer Ebene zwischen zwei Teilkörpern weiterhin jeder Teilkörper durch einen Teilkontakt kontaktiert ist. Zudem gewährleisten die Teilanschlüsse eine hohe Stromtragfähigkeit.

In einer Ausführungsform weist der Anschlusskontakt für jeden Teilkörper mindestens einen Teilanschluss und mindestens einen Teilkontakt auf. Beispielsweise befindet sich der Teilanschluss direkt unterhalb des jeweiligen Teilkontakts.

Das elektrische Bauelement ist erfindungsgemäß derart ausgebildet, dass es durch einen Schnitt entlang einer Ebene zwischen zwei der Teilkörper in kleinere Bauelemente separierbar ist, wobei jedes der kleineren Bauelemente wenigstens einen Teilkörper aufweist, der auf einem Sockel angeordnet ist und mit einem Anschlusskontakt verbunden ist. Jedes der kleineren Bauelemente kann die vorgehend beschriebenen Eigenschaften des Bauelements aufweisen. Somit wird eine Herstellung von Bauelementen in Form eines variablen "Endlos"-Designs ermöglicht.

Der Anschlusskontakt weist beispielsweise einen Materialverbund auf. Die Materialien sind dabei beispielsweise in Form von Schichten übereinander angeordnet. In einer Ausführungsform weist der Anschlusskontakt ein erstes Material und ein darauf angeordnetes zweites Material auf. Das erste Material ist vorzugsweise als erste Schicht und das zweite Material als zweite Schicht ausgebildet.

Das erste Material weist beispielsweise eine große elektrische Leitfähigkeit auf. Eine große elektrische Leitfähigkeit liegt beispielsweise bei mindestens 40 m/(Ω·mm²), vorzugsweise bei mindestens 50 m/(Ω·mm²). Vorzugsweise weist das erste Material auch eine große thermische Leitfähigkeit auf. Eine große thermische Leitfähigkeit liegt beispielsweise bei mindestens 250 W/(m·K), vorzugsweise bei mindestens 350 W/(m·K).

Das zweite Material weist vorzugsweise besonders gute mechanische und thermomechanische Eigenschaften auf. Insbesondere weist das zweite Material einen kleinen thermischen Ausdehnungskoeffizienten auf. Ein kleiner thermischer Ausdehnungskoeffizient liegt beispielsweise bei höchstens 5 ppm/K, vorzugsweise bei höchstens 2,5 ppm/K. Der Ausdehnungskoeffizient liegt vorzugsweise möglichst nahe am Ausdehnungskoeffizienten der Keramik. Auf diese Weise kann eine gute thermische Anpassung an die Keramik erreicht werden. Dadurch kann ein Spannungsaufbau bei Temperaturwechseln größtenteils vermieden und eine Rissbildung im Bauelement weitgehend verhindert werden.

In einer bevorzugten Ausführungsform weist das erste Material Kupfer auf oder besteht aus Kupfer. Kupfer weist eine besonders gute elektrische und thermische Leitfähigkeit auf.

Beispielsweise weist das zweite Material eine eisenhaltige Legierung auf. Vorzugsweise weist das zweite Material Invar auf oder besteht aus Invar. Als Invar wird eine Eisen-Nickel-Legierung mit ca. 1/3 Nickel und 2/3 Eisen bezeichnet. Dieses Material weist einen besonders niedrigen thermischen Ausdehnungskoeffizienten auf. Insbesondere liegt der thermische Ausdehnungskoeffizient nahe am Ausdehnungskoeffizienten der Keramik. Aufgrund der Kombination mit dem ersten Material kann auch bei einer geringen elektrischen Leitfähigkeit des zweiten Materials eine ausreichende Leitfähigkeit für den Anschlusskontakt gewährleistet werden.

In einer bevorzugten Ausführungsform weist das erste Material Kupfer auf oder besteht aus Kupfer. Beispielsweise weist das zweite Material eine eisenhaltige Legierung auf. Vorzugsweise weist das zweite Material Invar auf oder besteht aus Invar. Als Invar wird eine Eisen-Nickel-Legierung mit ca. 1/3 Nickel und 2/3 Eisen bezeichnet.

In einer Ausführungsform weist der Anschlusskontakt zudem ein drittes Material auf. Das dritte Material ist auf dem zweiten Material angeordnet, so dass das zweite Material zwischen dem ersten und dem dritten Material angeordnet ist. Das dritte Material ist vorzugsweise als dritte Schicht ausgebildet. Vorzugsweise ist das dritte Material gleich dem ersten Material. Vorzugsweise weist die dritte Schicht die gleiche Dicke auf wie die erste Schicht. Durch Ausbildung des dritten Materials kann vorzugsweise eine Verbiegung des Anschlusskontakts bei einer Temperaturänderung verhindert werden.

Insbesondere kann der Anschlusskontakt einen Materialverbund aus Kupfer-Invar-Kupfer aufweisen. Ein derartiger Verbund kann auch als CIC-Verbund bezeichnet werden.

Bei der Herstellung des Anschlusskontakts wird beispielsweise ein Blech aufweisend das zweite Material bereitgestellt. Auf das zweite Material wird dann das erste Material aufgebracht, beispielsweise aufgewalzt. Anschließend kann das das dritte Material auf die gegenüberliegende Seite des Blechs aufgebracht, insbesondere aufgewalzt, werden.

Der Anschlusskontakt kann auch einen anderen als den oben beschriebenen Aufbau aufweisen oder anderweitig hergestellt sein. Beispielsweise weist der Anschlusskontakt nur ein Material, z. B. nur Kupfer auf. Der Anschlusskontakt kann auch mehrere Materialien, beispielsweise einen Materialverbund aufweisen, wobei der Materialverbund nicht die Eigenschaft aufweist, wonach das erste Material eine große elektrische Leitfähigkeit und das zweite Material einen kleinen thermischen Ausdehnungskoeffizienten aufweist. Beispielsweise weist der Anschlusskontakt Kupfer auf und ist mit Silber beschichtet.

Gemäß einem weiteren Aspekt der vorliegenden Erfindung wird eine Bauelementanordnung aufweisend ein Bauelement und ein Träger, an dem das Bauelement befestigt ist, angegeben. Das Bauelement ist vorzugsweise wie das oben beschriebene Bauelement ausgebildet. Der Träger ist vorzugsweise wie oben beschrieben zum elektrischen Anschluss des Bauelements ausgebildet.

Der Anschlusskontakt ist mit dem Träger beispielsweise durch SMD- oder Pin-Montage verbunden. Der Anschlusskontakt kann mit dem Träger durch ein Verbindungsmaterial verbunden sein. Das Verbindungsmaterial ist beispielsweise ein Lot- oder Sintermaterial. Weiterhin kann der Anschlusskontakt auch durch Einpressung mit dem Träger verbunden sein.

Gemäß einem weiteren Aspekt der vorliegenden Erfindung wird ein Verfahren zur Herstellung eines Bauelements und oder/einer Bauelementanordnung angegeben. Das Bauelement bzw. die Bauelementanordnung ist beispielsweise wie oben beschrieben ausgebildet. Das Bauelement bzw. die Bauelementanordnung kann auch nur einen Teilkörper aufweisen, der auf dem Sockel angeordnet ist, wobei der Anschlusskontakt zum elektrischen Anschluss des Teilkörpers ausgebildet ist. Somit eignet sich das Verfahren zur Herstellung eines Bauelements bzw. einer Bauelementanordnung mit ein oder mehreren Teilkörpern und den weiteren oben beschriebenen Eigenschaften.

Gemäß dem Verfahren werden zwei Anschlusskontakte bereitgestellt und in einem späteren Schritt mit einem Sockel verbunden. In einem weiteren späteren Schritt werden die Anschlusskontakte zusammen mit dem Sockel separiert. Die Anschlusskontakte weisen die oben beschriebenen Teilkontakte auf und weisen vorzugsweise auch die oben beschriebenen Teilanschlüsse auf. Die Separierung erfolgt insbesondere in einer Ebene zwischen zwei benachbarten Teilkontakten bzw. Teilanschlüssen. Bei der Separierung werden sowohl der Sockel als auch die Anschlusskontakte geteilt. Auf diese Weise kann die Größe des Bauelements flexibel eingestellt werden.

In einer Ausführungsform des Verfahrens werden die Teilkörper bereitgestellt und auf dem Sockel angeordnet. Die Anordnung der Teilkörper auf dem Sockel kann vor oder nach dem Schritt des Separierens erfolgen. Beispielsweise wird der Sockel mit dem Anschlusskontakt zuerst durch Separieren auf eine gewünschte Größe gebracht. Anschließen werden die Teilkörper auf dem separierten Teil des Sockels angeordnet. Alternativ werden zuerst die Teilkörper auf dem Sockel angeordnet und anschließend wird die Anordnung aus Teilkörpern, Sockel und Anschlusskontakt in kleinere Bauelemente separiert.

Die Anordnung des wenigstens einen Teilkörpers erfolgt beispielsweise durch Klemmung. Dazu werden zwei Anschlusskontakte bereitgestellt und mit einem Sockel verbunden. Beispielsweise werden die Anschlusskontakte, insbesondere Kontaktbereiche der Anschlusskontakte, nach außen gebogen. Der Teilkörper wird zwischen den Anschlusskontakten angeordnet. Die Anschlusskontakte sind vorzugsweise federnd ausgebildet, so dass die Anschlusskontakte nach dem Loslassen zurückfedern und eine Klemmung des Teilkörpers erzeugen. Alternativ oder zusätzlich dazu kann der Sockel verbogen werden, um die Teilkörper zwischen den Anschlusskontakten klemmend anzuordnen.

Eine zusätzliche Befestigung der ein oder mehreren Teilkörper an den Anschlusskontakten erfolgt beispielsweise durch Löten oder Sintern. Insbesondere kann schon vor der Anordnung des Teilkörpers zwischen den Anschlusskontakten ein Kontaktmaterial, beispielsweise ein Lot- oder Sintermaterial, auf den Teilkörpern und/oder dem Anschlusskontakt aufgebracht sein.

In der vorliegenden Offenbarung sind mehrere Aspekte einer Erfindung beschrieben. Alle Eigenschaften, die in Bezug auf das Bauelement, die Bauelementanordnung und/oder das Verfahren offenbart sind, sind auch entsprechend in Bezug auf die jeweiligen anderen Aspekte offenbart, auch wenn die jeweilige Eigenschaft nicht explizit im Kontext der anderen Aspekte erwähnt wird.

Im Folgenden werden die hier beschriebenen Gegenstände anhand von schematischen Ausführungsbeispielen näher erläutert.

Es zeigen:
- Figur 1: eine schematische Darstellung eines Bauelements in einer perspektivischen Ansicht,
- Figuren 2A und 2B: eine Ausführungsform eines Bauelements in seitlichen Ansichten,
- Figuren 3A und 3B: eine weitere Ausführungsform eines Bauelements in seitlichen Ansichten,
- Figuren 4A und 4B: eine weitere Ausführungsform eines Bauelements in seitlichen Ansichten,
- Figur 5: einen Anbindung eines Bauelements an einen Träger gemäß einer Ausführungsform in einer Schnittansicht,
- Figuren 6A und 6B: eine weitere Ausführungsform eines Bauelements in perspektivischen Ansichten,
- Figur 7: Verfahrensschritte bei der Herstellung eines Bauelements im Flussdiagramm.

Vorzugsweise verweisen in den folgenden Figuren gleiche Bezugszeichen auf funktionell oder strukturell entsprechende Teile der verschiedenen Ausführungsformen.

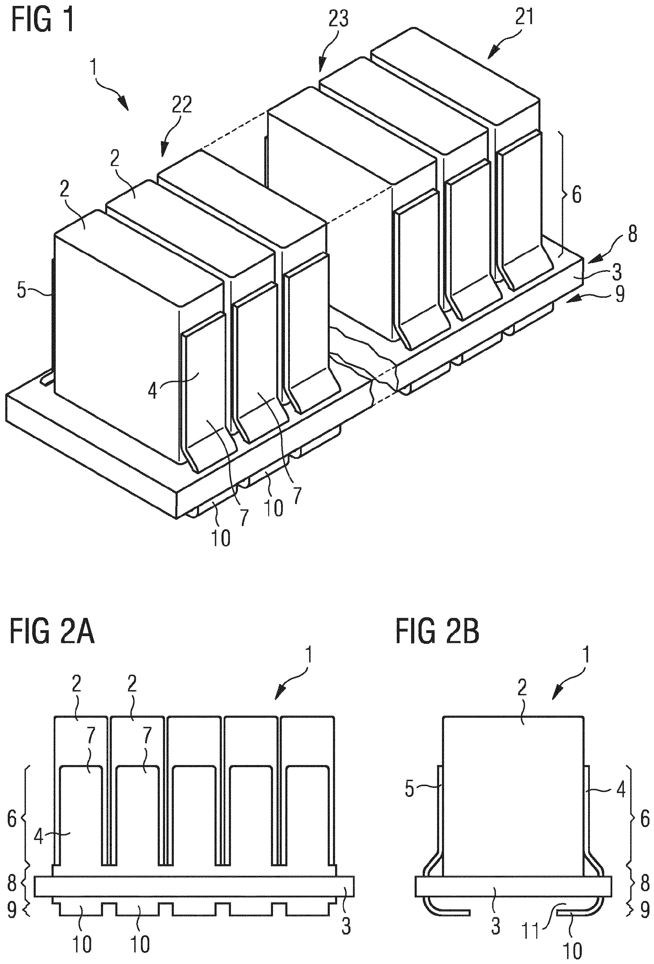

Figur 1 zeigt ein elektrisches Bauelement 1 in einer Konzeptansicht. Das Bauelement 1 ist in seiner Länge variabel, was durch die in der Mitte unterbrochene und gestrichelte Darstellung angedeutet ist.

Beispielsweise ist das Bauelement 1 als Kondensator, insbesondere als keramischer Kondensator ausgebildet. Beispielsweise ist das Bauelement 1 als Leistungskondensator ausgebildet.

Das Bauelement 1 weist mehrere Teilkörper 2 auf. Die Teilkörper 2 sind nebeneinander angeordnet. Alle Teilkörper 2 weisen vorzugsweise die gleichen Abmessungen auf. Die Anzahl der Teilkörper 2 im Bauelement 1 kann je nach den gewünschten Eigenschaften des Bauelements 1 variieren. Die Teilkörper 2 sind beispielsweise als Chips ausgebildet.

Die Teilkörper 2 bilden keinen monolithischen Sinterkörper. Beispielsweise sind die Teilkörper 2 voneinander beabstandet angeordnet. Beispielsweise befindet sich zwischen benachbarten Teilkörpern 2 ein Spalt. Der Spalt ist aus Gründen der erforderlichen Kapazitätsdichte und Miniaturisierung des Bauelements 1 vorzugsweise klein. Die Teilkörper 2 können auch aneinander befestigt sein, beispielsweise mittels eines elastischen Materials miteinander verbunden sein.

Die Teilkörper 2 können in ihrer Gesamtheit auch als Grundkörper 21 des Bauelements 1 bezeichnet werden. Der Grundkörper 21 weist eine Quaderform auf. Beispielsweise weist das Bauelement 1 zwischen ein bis zehn Teilkörper 2 auf, es sind aber auch größere Verbände möglich.

Die Teilkörper 2 weisen vorzugsweise jeweils ein keramisches Material auf. Beispielsweise weisen die Teilkörper 2 jeweils einen Vielschichtaufbau auf. Alle Schichten eines Teilkörpers 2 sind vorzugsweise gemeinsam gesintert. Insbesondere weisen die Teilkörper 2 jeweils einen Schichtstapel aus keramischen Schichten und dazwischen angeordneten Elektrodenschichten auf. Beispielsweise weisen die Elektrodenschichten Kupfer auf. Die Hauptebenen der Schichten der Teilkörper 2 verlaufen vorzugsweise parallel zur größten Seitenfläche des jeweiligen Teilkörpers 2. Vorzugsweise entspricht die Richtung, in der die Teilkörper 2 nebeneinander angeordnet sind, auch der Stapelrichtung der Schichten in den Teilkörpern 2.

Das Bauelement 1 weist einen Sockel 3 auf, auf dem die Teilkörper 2 angeordnet sind. Der Sockel 3 ist als Platte ausgebildet. Insbesondere weist der Sockel 3 eine Grundfläche auf, die mindestens so groß ist wie die Grundfläche des Grundkörpers 21. Vorzugsweise weist der Sockel 3 ein nicht-leitfähiges Material, beispielsweise ein Kunststoffmaterial, auf.

Das Bauelement 1 weist wenigstens einen Anschlusskontakt 4 zum elektrischen Anschluss des Bauelements 1 auf. Insbesondere weist das Bauelement 1 zwei Anschlusskontakte 4, 5 auf, die beispielsweise auf gegenüberliegenden Seiten der Teilkörper 2 angeordnet sind. Beispielsweise erstrecken sich die Anschlusskontakte 4, 5 jeweils vollständig über zwei Längsseiten des Grundkörpers 21. Durch die Anschlusskontakte 4, 5 sind die Teilkörper 2 elektrisch parallel miteinander verschaltet.

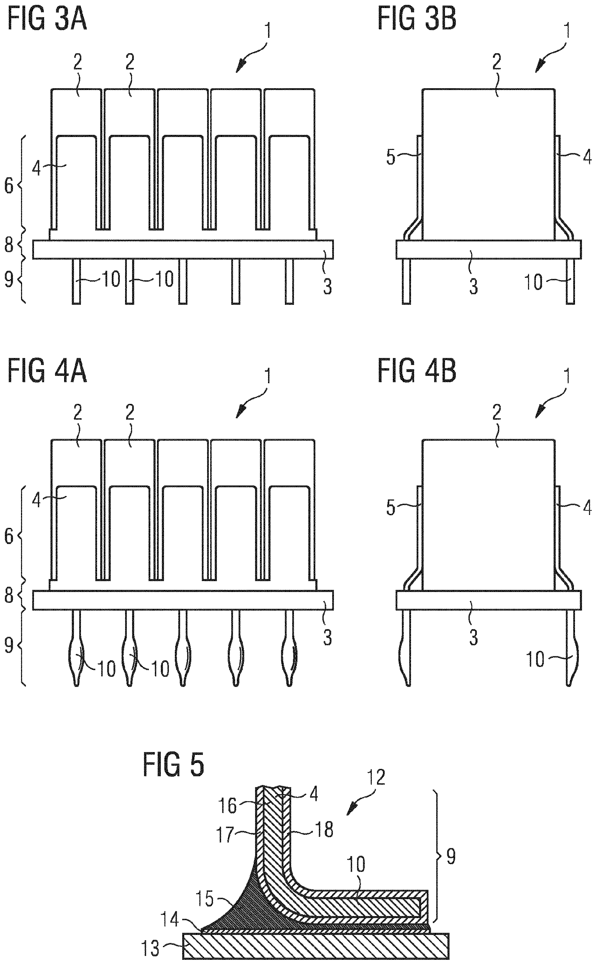

Die Anschlusskontakte 4, 5 sind zur Verbindung des Bauelements 1 mit einem Träger (siehe z. B. Figur 5) ausgebildet. Insbesondere sind die Anschlusskontakte 4, 5 zum elektrischen Anschluss des Bauelements 1 ausgebildet. Weiterhin können die Anschlusskontakte 4, 5 auch zur mechanischen Befestigung des Bauelements 1 am Träger dienen. Die Anschlusskontakte 4, 5 können auch eine thermische Anbindung an den Träger gewährleisten.

Bei dem Träger handelt es sich vorzugsweise um eine Leiterplatte. Beispielsweise ist die Leiterplatte als FR4-Platine ausgebildet. Es kann sich auch um ein keramisches Substrat handeln. Beispielsweise ist der Träger als DCB (direct copper bonded)-Substrat ausgebildet, bei dem Kupfer auf eine Keramik aufgebracht ist.

Vorzugsweise sind die Anschlusskontakte 4, 5 jeweils aus einem Blech gebildet. Insbesondere kann es sich bei den Anschlusskontakten 4, 5 um einen Anschlusswinkel oder Leadframe handeln. Die Anschlusskontakte 4, 5 weisen beispielsweise Kupfer und/oder einen mehrschichtigen Metallverbund auf.

Die Anschlusskontakte 4, 5 sind mit dem Sockel 3 verbunden. Beispielsweise sind die Anschlusskontakte 4, 5 durch den Sockel 3 hindurchgeführt. Beispielsweise ist der Sockel 3 im Spritzgussverfahren hergestellt. Die Anschlusskontakte 4, 5 sind beispielsweise vom Material des Sockels 3 umspritzt. Der Sockel 3 kann auch separat von den Anschlusskontakten 4, 5 hergestellt werden und Einschnitte aufweisen, durch die die Anschlusskontakte 4, 5 in den Sockel 3 eingeführt werden. Alternativ können die Anschlusskontakte 4, 5 auch um den Sockel 3, beispielsweise um eine Schmalseite des Sockels 3, herumgeführt sein.

Die Anschlusskontakte 4, 5 sind vorzugsweise nicht mit dem Sockel 3 elektrisch verschaltet. Der Sockel 3 weist vorzugsweise keine elektrischen Kontakte zum Anschluss der Anschlusskontakte 4, 5 auf. Der Sockel 3 kann zur mechanischen Stabilisierung der Anschlusskontakte 4, 5 beitragen.

Im Folgenden wird nur ein Anschlusskontakt 4 im Detail beschrieben, wobei der andere Anschlusskontakt 5 entsprechend ausgebildet sein kann.

Der Anschlusskontakt 4 weist einen Kontaktbereich 6 zur Kontaktierung der Teilkörper 2 auf. Der Anschlusskontakt 4 weist im Kontaktbereich 6 mehrere Teilkontakte 7 auf, wobei jeder Teilkontakt 7 vorzugsweise genau einen der Teilkörper 2 kontaktiert. Die Teilkontakte 7 liegen beispielsweise jeweils an einem der Teilkörper 2 an. Die Teilkontakte 7 sind vorzugsweise jeweils an einem der Teilkörper 2 befestigt. Die Teilkontakte 7 sind beispielsweise als Kontaktarme oder Kontaktfinger ausgebildet. Jeder Teilkontakt 7 kann beispielsweise auch zwei oder mehr Kontaktarme oder Kontaktfinger aufweisen. Zwischen den Teilkontakten 7 erstreckt sich jeweils ein Spalt, der die Teilkontakte 7 voneinander separiert.

Die Teilkontakte 7 sind beispielsweise in einem Verbindungsbereich 8 des Anschlusskontakts 4 miteinander verbunden. Der Verbindungsbereich 8 liegt vorzugsweise lediglich in der Nähe oder innerhalb des Sockels 3. Beispielsweise kann der Verbindungsbereich 8 ganz im Inneren des Sockels 3 liegen, wie es z. B. in Figur 1 gezeigt ist.

Durch das Vorhandensein der Teilkontakte 7 wird zum einen eine mechanische Entlastung des Bauelements 1 ermöglicht. Insbesondere können die Teilkontakte 7 auch in Stapelrichtung der Teilkörper 2 eine gewisse Flexibilität aufweisen. Weiterhin kann eine derartige Ausgestaltung auch vorteilhaft für die Stromtragfähigkeit und die Entwärmungsfähigkeit des Bauelements 1 sein.

Beispielsweise sind Teilkörper 2 klemmend zwischen den Anschlusskontakten 4, 5 angeordnet werden. Vorzugsweise sind die Teilkörper 2 zusätzlich zur klemmenden Anordnung durch ein Kontaktmaterial an den Anschlusskontakten 4, 5 befestigt. Beispielsweise sind die Anschlusskontakte 4, 5 mittels eines Sintermaterials an den Teilkörpern 2 befestigt.

Die Teilkontakte 7 sind beispielsweise jeweils an einem Außenkontakt der Teilkörper 2 befestigt. Insbesondere weist jeder der Teilkörper 2 einen Außenkontakt auf. Der Außenkontakt weist beispielsweise ein oder mehrere gesputterte Schichten auf. In einer Ausführungsform handelt es sich um einen Cr/Ni/Ag-Schichtaufbau.

Der Anschlusskontakt 4 weist einen Anschlussbereich 9 zur elektrischen und/oder mechanischen Verbindung mit dem Träger auf. Vorzugsweise weist der Anschlussbereich 9 mehrere Teilanschlüsse 10 zur mechanischen und/oder elektrischen Verbindung mit dem Träger auf. Dies ermöglicht eine stabile Befestigung am Träger auch bei einer größeren Bauform des Bauelements 1.

Der Anschlusskontakt 4 weist vorzugsweise jeweils für jeden der Teilkörper 2 wenigstens einen Teilanschluss 10 auf. Die Teilanschlüsse 10 stellen beispielsweise jeweils eine Verlängerung der Teilkontakte 7 in Richtung des Trägers dar. Die Teilanschlüsse 10 können ebenfalls in Form von Armen oder Fingern ausgebildet sein. Beispielsweise sind die Teilanschlüsse 10 ebenfalls nur im Verbindungsbereich 8 des Anschlusskontaktes 4 miteinander verbunden.

Vorzugsweise sind die verschiedenen Teile des Anschlusskontaktes 4 derart miteinander verbunden, dass der Anschlusskontakt 4 einteilig ausgebildet ist.

Der Anschlussbereich 9 und insbesondere die Teilanschlüsse 10 können je nach einem gewünschten Anbindungskonzept ausgestaltet sein. Beispielsweise sind die Teilanschlüsse 10 zur SMD-Montage, zur Lötmontage oder zur Einpressmontage ausgebildet. Verschiedene Ausgestaltungen des Anschlussbereichs 9 sind in den nachfolgenden Figuren gezeigt.

Die gezeigte Bauform des Bauelements 1 ermöglicht eine Herstellung in Form eines variablen "Endlos"-Designs. Beispielsweise kann das gezeigte Bauelement 1 durch Vereinzelung aus einem größeren Bauelement gebildet sein. Beispielsweise kann das gezeigte Bauelement 1 auch noch in kleinere Bauelemente 22, 23 separiert werden, was auch durch die in der Mitte unterbrochene und gestrichelte Darstellung angedeutet sein kann.

Die Separierbarkeit wird insbesondere durch das Vorhandensein der einzelnen Teilkörper 2 und durch die Form der Anschlusskontakte 4, 5 gewährleistet. So ermöglichen die Teilkontakte 7 und Teilanschlüsse 10 eine Separierung des Anschlusskontakts 4 derart, dass nach einem Schnitt entlang einer Ebene zwischen zwei benachbarten Teilkörpern 2 für jeden Teilkörper 2 weiterhin ein Teilkontakt 7 und ein Teilanschluss 10 vorhanden ist. Auf diese Weise kann jeder Teilkörper 2 auch nach einer Separierung noch kontaktiert werden, ohne dass eine Umgestaltung der Anschlusskontakte 4, 5 notwendig ist. Beispielsweise kann der Anschlusskontakt 4 durch Durchbrechen der Verbindungsstücke der Teilkontakte 7 bzw. Teilanschlüsse 10, beispielsweise von Stegen, separiert werden.

Mit diesem Aufbaukonzept können verschiedene Spannungsklassen und Kapazitätsgrößen in vielen Kontaktierungstechniken dargestellt werden. Die Spannungsklasse eines Teilkörpers 2 wird durch die genaue Stapelfolge der Schichten im inneren Aufbau des Teilkörpers 2 festgelegt. Da die Teilkörper 2 alle die gleiche Außengeometrie aufweisen, können sie im Bauelement 1 beliebig ausgetauscht werden. Durch Mischen von Teilkörpern 2 mit unterschiedlichem Kapazitätsverlauf über Bias kann dieser in gewissen Grenzen verändert und angepasst werden. Die Gesamtkapazität des Bauelements 1 wird durch die verbauten Teilkörper 2 festgelegt. Dies eröffnet dem Designprozess auf Modulebene neue Freiheitsgrade für die Optimierung von Bauraum, Leistungsdichte und Effizienz.

Die Figuren 2A und 2B zeigen eine Ausführungsform eines Bauelements 1 in seitlichen Ansichten. Figur 2A zeigt dabei eine Aufsicht auf eine Seitenfläche des Anschlusskontakts 4 und Figur 2B zeigt eine dazu um 90° gedrehte Aufsicht auf einen der Teilkörper 2. Das Bauelement 1 ist ähnlich wie das Bauelement 1 aus Figur 1 ausgebildet.

Wie in Figur 2A zu sehen ist, erstrecken sich die Teilkontakte 7 in Form von Kontaktarmen vom Sockel 3 nach oben. Die Teilkontakte 7 sind parallel zueinander ausgebildet. Die Teilkontakte 7 sind im Bereich des Sockels 3 miteinander verbunden. Der Verbindungsbereich 8 erstreckt sich im Unterschied zu Figur 1 auch in einen kleinen Bereich oberhalb bzw. unterhalb des Sockels 3. Außer im Verbindungsbereich 8 weisen die Teilkontakte 7 keine weitere Verbindung miteinander auf. Die Teilkontakte 7 können, wie in Figur 1 gezeigt, auch nur innerhalb des Sockels 3 miteinander verbunden sein oder auch keine Verbindung miteinander aufweisen. Analog sind auch die Teilanschlüsse 10 im Verbindungsbereich 8 miteinander verbunden.

Wie in Figur 2B zu sehen ist, sind die Anschlusskontakte 4, 5 beispielsweise zur SMD-Kontaktierung ausgebildet. Dazu ist der Bereich der Anschlusskontakte 4, 5 auf der von den Teilkörpern 2 abgewandten Seite des Sockels 3 nach innen gebogen. Insbesondere sind die Teilanschlüsse 10 nach innen gebogen. Die Teilanschlüsse 10 sind beispielsweise vollständig unterhalb des Sockels 3 angeordnet. Alternativ können die Teilanschlüsse 10 auch nach außen gebogen sein und aus einer Grundform des Sockels 3 hervorstehen.

Beispielsweise werden die Anschlusskontakte 4, 5 durch Verlötung mit einem Träger verbunden. Vorzugsweise weisen alle involvierten Komponenten und Materialien eine hohe Temperaturstabilität auf, so dass beispielsweise auch eine Sinterverbindung möglich ist.

Die Anschlusskontakte 4, 5 sind vorzugsweise derart ausgebildet, dass der Sockel 3 in einem Abstand vom Träger angeordnet ist. Insbesondere befindet sich zwischen dem Sockel 3 und dem Anschlussbereich 9 ein Luftspalt 11.

Die Figuren 3A und 3B zeigen eine weitere Ausführungsform eines Bauelements 1 in seitlichen Aufsichten. Im Unterschied zu dem in den Figuren 2A und 2B gezeigten Bauelement 1 weisen die Anschlusskontakte 4, 5 Pins zur Anbindung an einen Träger auf. Insbesondere sind die Teilanschlüsse 10 jeweils als Pins ausgebildet. Die Teilanschlüsse 10 können insbesondere als Lötpins ausgebildet sein.

Die Teilanschlüsse 10 sind vorliegend unterhalb des Sockels 3 nicht miteinander verbunden. Beispielsweise sind die Teilanschlüsse 10 innerhalb des Sockels 3 miteinander verbunden. Insbesondere kann der Anschlusskontakt 4 einteilig ausgebildet sein.

Die Figuren 4A und 4B zeigen eine weitere Ausführungsform eines Bauelements 1 in seitlichen Aufsichten. Im Unterschied zu dem in den Figuren 3A und 3B gezeigten Bauelement 1 weisen die Anschlusskontakte 4, 5 Einpressstifte zur Anbindung an einen Träger auf. Insbesondere ist jeder der Teilanschlüsse 10 als Einpressstift ausgebildet. Dabei weist jeder Teilanschluss 10 eine Verdickung auf, um eine stabile Befestigung an einem Träger zu gewährleisten.

Figur 5 zeigt einen Ausschnitt aus einer Bauelementanordnung 12, bei dem ein Bauelement 1 an einem Träger 13 befestigt ist. Insbesondere ist hier eine Verbindung des Anschlussbereichs 9 mit dem Träger 13 gezeigt. Das Bauelement 1 ist beispielsweise wie in den vorhergehenden Figuren ausgebildet. Insbesondere können die Anschlussbereiche 9 wie in den Figuren 2A und 2B gezeigt zur SMD-Kontaktierung ausgebildet sein.

Der Träger 13 ist insbesondere als Platine ausgebildet. Beispielsweise handelt es sich um ein FR4- oder keramisches Substrat. Der Träger 13 weist wenigstens eine Kontaktstelle 14 auf, an dem der Anschlussbereich 9 des Anschlusskontakts 4 befestigt ist. Der Träger 13 mit der Kontaktstelle 14 ist beispielsweise als Leiterplatte mit Kontaktpads oder als keramisches Substrat mit Kontaktflächen, insbesondere als DCB-Substrat ausgebildet. Beispielsweise handelt es sich bei der Kontaktstelle 14 um einen Lötpad, einen Cu-Kontakt oder einen Ni-Au-Kontakt.

Beispielsweise ist der Anschlussbereich 9 mit der Kontaktstelle 14 verlötet oder versintert. Dazu ist beispielsweise ein Verbindungsmaterial 15 in Form eines Lot- oder Sintermaterials vorgesehen. Als Lotmaterial wird beispielsweise ein SAC-Lot verwendet. Als Sintermaterial wird beispielsweise Silber oder Kupfer verwendet.

Der Anschlusskontakt 4 weist beispielsweise neben einer hohen thermischen und elektrischen Leitfähigkeit einen möglichst geringen thermischen Ausdehnungskoeffizienten auf. Diese unterschiedlichen Eigenschaften werden beispielsweise durch einen Materialverbund, insbesondere durch einen mehrschichtigen Aufbau des Anschlusskontakts 4 gewährleistet.

Der Anschlusskontakt 4 weist beispielsweise ein Grundmaterial 16 auf. Auf dem Grundmaterial 16 können ein oder mehrere weitere Schichten 17, 18 aufgebracht sein. Beispielsweise weist das Grundmaterial Kupfer auf oder besteht aus Kupfer. Das Grundmaterial 16 kann auch mehrere unterschiedliche, aufeinander angeordnete Materialien aufweisen.

Beispielsweise weist der Anschlusskontakt einen CIC (Kupfer-Invar-Kupfer)-Aufbau mit beidseitig aufgebrachten Galvanikschichten auf.

Die weiteren Schichten 17, 18 bilden beispielsweise die Außenseiten des Anschlusskontakts 4. Beispielsweise handelt es sich um Galvanikschichten, insbesondere um Nickel- oder Silberschichten.

Der Anschlusskontakt 4 des erfindungsgemäßen Bauelements 1 kann den vorgehend beschriebenen Materialaufbau aufweisen. Der Anschlusskontakt 4 kann auch einen anderen Materialaufbau aufweisen. Weiterhin kann der Anschlusskontakt 4 wie vorgehend beschrieben an einem Träger 13 befestigt sein. Der Anschlusskontakt 4 kann jedoch auch anderweitig an einem Träger 13 befestigt sein.

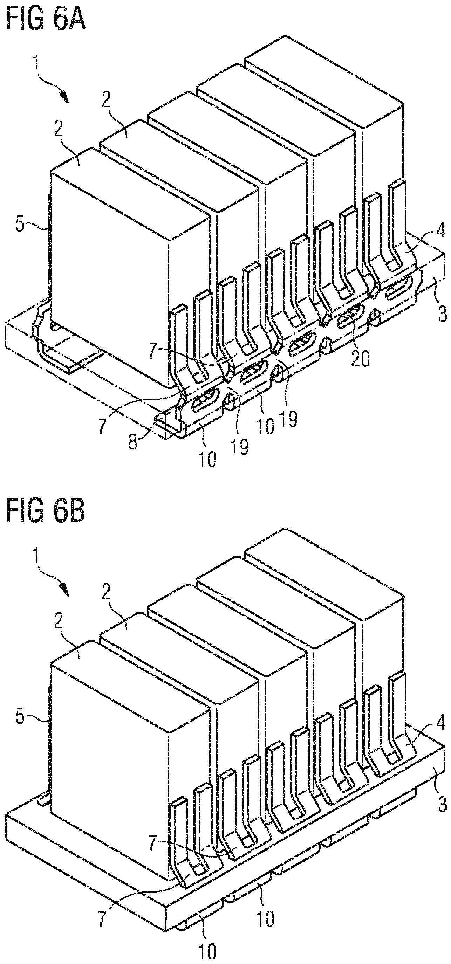

Die Figuren 6A und 6B zeigen eine weitere Ausführungsform eines Bauelements 1 in perspektivischen Ansichten. In Figur 6A ist der Sockel 3 transparent durch gestrichelte Kanten angedeutet.

Im Unterschied zu dem in den Figuren 2A und 2B gezeigtem Bauelement 1 weisen die Teilkontakte 7 jeweils zwei Arme auf. Die beiden Arme liegen an einem der Teilkörper 2 an. Die Teilanschlüsse 10 sind beispielsweise wie in den Figuren 2A und 2b ausgebildet.

Wie in Figur 6A zu sehen ist, ist der Anschlusskontakt 4 einteilig ausgebildet. Der Verbindungsbereich 8 zwischen den Teilkontakten 7 bzw. den Teilanschlüssen 10 ist im Inneren des Sockels 3 angeordnet. Die Teilkontakte 7 bzw. die Teilanschlüsse 10 sind durch Stege 19 miteinander verbunden. Durch Durchbrechen der Stege 19 kann eine Vereinzelung des Bauelements 1 erfolgen.

Weiterhin weist der Anschlusskontakt 4 innerhalb des Sockels 3 Aussparungen 20 auf. Die Aussparungen 20 dienen beispielsweise der Verbesserung der Befestigung des Anschlusskontakts 4 mit dem Sockel 3.

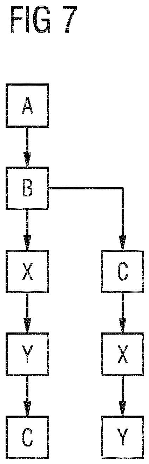

Im Folgenden werden zwei Verfahren zur Herstellung eines Bauelementes 1 anhand des in Figur 7 gezeigten Flussdiagramms erläutert. Das Bauelement 1 ist beispielsweise wie in den Figuren 1 bis 6B ausgebildet. Das Bauelement 1 kann auch anstelle von mehreren Teilkörpern 2 nur einen Teilkörper 2 aufweisen.

In einem Schritt A wird ein Anschlusskontakt 4 bereitgestellt. Der Anschlusskontakt 4 ist beispielsweise wie in den vorhergehenden Figuren ausgebildet. Insbesondere ist der Anschlusskontakt 4 als Blech, beispielsweise als Leadframe ausgebildet. Der Anschlusskontakt 4 ist vorzugsweise einteilig ausgebildet. Vorzugsweise werden zwei derartige Anschlusskontakte 4, 5 bereitgestellt.

In einem Schritt B werden die ein oder mehreren Anschlusskontakte 4, 5 mit einem Sockel 3 verbunden. Der Sockel 3 ist beispielsweise wie in den vorhergehenden Figuren ausgebildet. Beispielsweise weist der Sockel 3 ein Kunststoffmaterial auf. Die Anschlusskontakte 4, 5 werden beispielsweise in eine Spritzgussform eingelegt und mit dem Material des Sockels 3 umspritzt. In diesem erfolgt die Einbettung in den Sockel 3 gleichzeitig mit der Herstellung des Sockels 3.

Alternativ kann der Sockel 3 auch Einschnitte aufweisen, durch die ein oder mehreren Anschlusskontakte 4, 5 geführt werden. In diesem Fall wird der Sockel 3 zuerst bereitgestellt und nachfolgend mit den Anschlusskontakten 4, 5 verbunden. Die Anschlusskontakte 4, 5 können auch durch den Sockel 3 herumgeführt sein. Beispielsweise können die Anschlusskontakte 4, 5 auf den Sockel 3 aufgeklemmt werden.

In einem Schritt X werden ein oder mehrere Teilkörper 2 bereitgestellt. Die Teilkörper 2 sind beispielsweise wie in den vorhergehenden Figuren ausgebildet.

Die Teilkörper 2 werden auf dem Sockel 3 angeordnet. Beispielsweise werden die Teilkörper 2 zwischen zwei Anschlusskontakten 4, 5 eingeklemmt. Dazu werden beispielsweise die Anschlusskontakte 4, 5, insbesondere deren Kontaktbereiche 6, nach außen gebogen. Nach der Anordnung der Teilkörper 2 zwischen den Anschlusskontakten 4, 5 werden die Anschlusskontakte 4, 5 wieder losgelassen, so dass die Anschlusskontakte 4, 5 zurückfedern und eine Klemmung der Teilkörper 2 erfolgt. Alternativ oder zusätzlich dazu kann auch der Sockel 3 verbogen werden, um die Anschlusskontakte 4, 5 nach außen zu biegen und die Teilkörper 2 zwischen den Anschlusskontakten 4, 5 klemmend anzuordnen.

In einem Schritt Y erfolgt eine weitere Befestigung der Teilkörper 2 an den Anschlusskontakten 4, 5, beispielsweise durch Verlötung oder Versinterung. Insbesondere kann schon vor der Anordnung der Teilkörper 2 zwischen den Anschlusskontakten 4, 5 ein Kontaktmittel, beispielsweise ein Lot- oder Sintermaterial, auf den Teilkörpern 2 und/oder den Anschlusskontakten 4, 5 angebracht sein.

Nach der Anordnung der Teilkörper 2 zwischen den Anschlusskontakten 4, 5 erfolgt eine Erwärmung, so dass ein Aufschmelzen des Lotmaterials oder eine Sinterung eines Sintermaterials erfolgt. Auf diese Weise kann der elektrische Kontakt zwischen den Teilkörpern 2 und den Anschlusskontakten 4, 5 sichergestellt werden. Beispielsweise wird zur Verbindung ein Niedertemperatur-Sinterprozess, insbesondere bei einer Temperatur im Bereich von 250°C, durchgeführt.

In einem Schritt C erfolgt eine Vereinzelung in kleinere Bauelemente einer gewünschten Größe, insbesondere mit einer gewünschten Anzahl an Teilkörpern 2. Dazu wird das Bauelement 1 durch einen Schnitt entlang einer Ebene zwischen zwei angrenzenden Teilkörpern 2 separiert. Aufgrund der Ausgestaltung der Anschlusskontakte 4, 5 mit einer Vielzahl von Teilkontakten 7 und Teilanschlüssen 10, insbesondere einen Teilkontakt 7 und einen Teilanschluss 10 für jeden Teilkörper 2, ist eine beliebige Vereinzelung unter Beibehaltung der Kontaktierung für jeden Teilkörper 2 möglich.

Alternativ kann eine Vereinzelung auch schon vor der Anordnung der Teilkörper 2 zwischen den Anschlusskontakten 4, 5 erfolgen. Dazu wird beispielsweise nach Schritt B in einem Schritt C ein Schnitt in einer Ebene zwischen benachbarten Teilkontakten 7 ausgeführt. Die Teilkörper 2 werden danach zwischen den Anschlusskontakten 4, 5 gemäß Schritt X angeordnet und gemäß Schritt Y zusätzlich befestigt.

### Bezugszeichenliste

- 1: Bauelement
- 2: Teilkörper
- 3: Sockel
- 4: Anschlusskontakt
- 5: Anschlusskontakt
- 6: Kontaktbereich
- 7: Teilkontakt
- 8: Verbindungsbereich
- 9: Anschlussbereich
- 10: Teilanschluss
- 11: Luftspalt
- 12: Bauelementanordnung
- 13: Träger
- 14: Kontaktstelle
- 15: Verbindungsmaterial
- 16: Grundmaterial
- 17: weitere Schicht
- 18: weitere Schicht
- 19: Steg
- 20: Aussparung
- 21: Grundkörper
- 22: kleineres Bauelement
- 23: kleineres Bauelement

## Patentansprüche

1. Elektrisches Bauelement (1), aufweisend mehrere Teilkörper (2), einen Sockel (3), auf dem die Teilkörper (2) angeordnet sind, und zwei Anschlusskontakte (4, 5) zum elektrischen Anschluss der Teilkörper (2) an einem Träger (13), wobei die Anschlusskontakte (4, 5) an gegenüberliegenden Seiten der Teilkörper (2) angeordnet sind, **gekennzeichnet dadurch, dass** das Bauelement (1) durch einen Schnitt entlang einer Ebene zwischen zwei der Teilkörper (2) in kleinere Bauelemente (22, 23) derart separierbar ist, dass sowohl der Sockel (3) als auch die Anschlusskontakte (4, 5) geteilt werden, wobei jedes der kleineren Bauelemente (22, 23) wenigstens einen Teilkörper (2) aufweist, der auf einem Sockel (3) angeordnet ist und mit einem Anschlusskontakt (4, 5) verbunden ist.

2. Elektrisches Bauelement nach Anspruch 1, bei dem die Teilkörper (2) nicht aneinander befestigt sind.

3. Elektrisches Bauelement nach einem der vorhergehenden Ansprüche, bei dem die Anschlusskontakte (4, 5) durch den Sockel (3) hindurchgeführt sind.

4. Elektrisches Bauelement nach einem der vorhergehenden Ansprüche, bei dem die Anschlusskontakte (4, 5) zur SMD- oder Pin-Montage ausgebildet sind.

5. Elektrisches Bauelement nach einem der vorhergehenden Ansprüche, wobei die Teilkörper (2) zwischen den Anschlusskontakten (4, 5) eingeklemmt sind.

6. Elektrisches Bauelement nach einem der vorhergehenden Ansprüche, bei dem die Anschlusskontakte (4, 5) jeweils mehrere Teilkontakte (7) aufweisen, wobei jeder Teilkontakt (7) einen der Teilkörper (2) kontaktiert.

7. Elektrisches Bauelement nach Anspruch 6, bei dem die Teilkontakte (7) durch Stege (19) miteinander verbunden sind.

8. Elektrisches Bauelement nach einem der vorhergehenden Ansprüche, bei dem die Anschlusskontakte (4, 5) jeweils mehrere Teilanschlüsse (10) zur elektrischen Verbindung mit dem Träger (13) aufweisen.

9. Elektrisches Bauelement nach einem der vorhergehenden Ansprüche, bei dem die Anschlusskontakte (4, 5) jeweils ein erstes Material (M1) und ein darauf angeordnetes zweites Material (M2) aufweisen, bei dem das erste Material (M1) Kupfer und das zweite Material (M2) Invar aufweist.

10. Bauelementanordnung
mit einem elektrischen Bauelement (1) nach einem der vorhergehenden Ansprüche und einem Träger (13), an dem das Bauelement (1) befestigt ist.

11. Verfahren zur Herstellung eines Bauelements aufweisend ein oder mehrere Teilkörper (2), einen Sockel (3), auf dem die Teilkörper (2) angeordnet ist, und zwei Anschlusskontakte (4, 5) zum elektrischen Anschluss der Teilkörper (2) an einen Träger (13), aufweisend die Schritte
A) Bereitstellen von zwei Anschlusskontakten (4, 5),
B) Verbinden der Anschlusskontakte (4, 5) mit einem Sockel (3), derart, dass die Anschlusskontakte (4, 5) zur Anordnung an gegenüberliegenden Seiten der Teilkörper (2) ausgebildet sind,
C) Separieren der Anschlusskontakte (4, 5) zusammen mit dem Sockel (3), wobei sowohl der Sockel als auch die Anschlusskontakte (4, 5) geteilt werden.

12. Verfahren nach Anspruch 11,
wobei in einem weiteren Schritt ein oder mehrere Teilkörper (2) bereitgestellt und auf dem Sockel (3) angeordnet werden.

13. Verfahren nach Anspruch 12,
wobei der Schritt C) des Separierens nach dem Anordnen der Teilkörper (2) auf dem Sockel (3) erfolgt.

14. Verfahren nach Anspruch 12,
wobei der Schritt C) des Separierens vor dem Anordnen der Teilkörper (2) auf dem Sockel (3) erfolgt.

15. Verfahren nach einem der Ansprüche 11 bis 14,
wobei die Teilkörper (2) zwischen den Anschlusskontakten (4, 5) durch Klemmung befestigt werden.

## Claims

1. Electrical component (1), having a plurality of partial bodies (2), a base (3) on which the partial bodies (2) are arranged, and two connection contacts (4, 5) for electrically connecting the partial bodies (2) to a carrier (13), wherein the connection contacts (4, 5) are arranged on opposite sides of the partial bodies (2), **characterized in that** the component (1) can be separated into smaller components (22, 23) by a cut along a plane between two of the partial bodies (2) in such a way that both the base (3) and the connection contacts (4, 5) are divided, wherein each of the smaller components (22, 23) has at least one partial body (2) which is arranged on a base (3) and is connected to a connection contact (4, 5).

2. Electrical component according to Claim 1, in which the partial bodies (2) are not fastened to one another.

3. Electrical component according to either of the preceding claims, in which the connection contacts (4, 5) are routed through the base (3).

4. Electrical component according to one of the preceding claims, in which the connection contacts (4, 5) are designed for SMD or pin mounting.

5. Electrical component according to one of the preceding claims, wherein the partial bodies (2) are clamped between the connection contacts (4, 5).

6. Electrical component according to one of the preceding claims, in which the connection contacts (4, 5) each have a plurality of partial contacts (7), wherein each partial contact (7) makes contact with one of the partial bodies (2).

7. Electrical component according to Claim 6, in which the partial contacts (7) are connected to one another by webs (19).

8. Electrical component according to one of the preceding claims, in which the connection contacts (4, 5) each have a plurality of partial connections (10) for electrical connection to the carrier (13).

9. Electrical component according to one of the preceding claims, in which the connection contacts (4, 5) each comprise a first material (M1) and a second material (M2) which is arranged on said first material, in which the first material (M1) comprises copper and the second material (M2) comprises Invar.

10. Component arrangement
comprising an electrical component (1) according to one of the preceding claims and a carrier (13) to which the component (1) is fastened.

11. Method for producing a component having one or more partial bodies (2), a base (3) on which the partial bodies (2) are arranged, and two connection contacts (4, 5) for electrically connecting the partial bodies (2) to a carrier (13), comprising the steps of
A) providing two connection contacts (4, 5),
B) connecting the connection contacts (4, 5) to a base (3) in such a way that the connection contacts (4, 5) are designed for arrangement on opposite sides of the partial bodies (2),
C) separating the connection contacts (4, 5) together with the base (3), wherein both the base and the connection contacts (4, 5) are divided.

12. Method according to Claim 11,
wherein, in a further step, one or more partial bodies (2) are provided and arranged on the base (3).

13. Method according to Claim 12,
wherein separating step C) is performed after the partial bodies (2) are arranged on the base (3).

14. Method according to Claim 12,
wherein separating step C) is performed before the partial bodies (2) are arranged on the base (3).

15. Method according to one of Claims 11 to 14,
wherein the partial bodies (2) are fastened between the connection contacts (4, 5) by clamping.

## Revendications

1. Composant électrique (1) comportant une pluralité de parties de corps (2), une base (3) sur laquelle les parties de corps (2) sont disposées, et deux contacts de connexion (4, 5) destinés à la connexion électrique des parties de corps (2) à un support (13), les contacts de connexion (4, 5) étant disposés sur des côtés opposés des parties de corps (2), **caractérisé en ce que** le composant (1) peut être divisé en composants plus petits (22, 22) par une coupe effectuée le long d'un plan entre deux des parties de corps (2) de telle manière que la base (3) et les contacts de connexion (4, 5) soient séparés, chacun des plus petits composants (22, 23) comportant au moins une partie de corps (2) qui est disposée sur une base (3) et qui est reliée à un contact de connexion (4, 5).

2. Composant électrique selon la revendication 1, dans lequel les parties de corps (2) ne sont pas fixées les unes aux autres.

3. Composant électrique selon l'une des revendications précédentes, dans lequel les contacts de connexion (4, 5) sont guidés à travers la base (3}.

4. Composant électrique selon l'une des revendications précédentes, dans lequel les contacts de connexion (4, 5) sont conçus pour un montage SMD ou Pin.

5. Composant électrique selon l'une des revendications précédentes, les parties de corps (2) étant serrées entre les contacts de connexion (4, 5).

6. Composant électrique selon l'une des revendications précédentes, les contacts de connexion (4, 5) comportant chacun une pluralité de parties de contact (7), chaque partie de contact (7) venant en contact avec l'une des parties de corps (2).

7. Composant électrique selon la revendication 6, dans lequel les parties de contact (7) sont reliées entre elles par des nervures (19).

8. Composant électrique selon l'une des revendications précédentes, dans lequel les contacts de connexion (4, 5) comportent chacun une pluralité de parties de connexions (10) destinées à la connexion électrique au support (13).

9. Composant électrique selon l'une des revendications précédentes, dans lequel les contacts de connexion (4, 5) comportent chacun un premier matériau (Ml) et un deuxième matériau (M2) disposé sur le premier matériau, dans lequel le premier matériau (Ml) est le cuivre et le deuxième matériau (M2) est l'Invar.

10. Ensemble de composant comprenant un composant électrique (1) selon l'une des revendications précédentes et un support (13) sur lequel le composant (1) est fixé.

11. Procédé de fabrication d'un composant comportant une ou plusieurs parties de corps (2), une base (3) sur laquelle les parties de corps (2) sont disposées, et deux contacts de connexion (4, 5) destinés à la connexion électrique des parties de corps (2) à un support (13), le procédé comprenant les étapes suivantes
A) fournir deux contacts de connexion (4, 5),
B) relier les contacts de connexion (4, 5) à une base (3) de telle sorte que les contacts de connexion (4, 5) soient conçus pour être disposés sur des côtés opposés des parties de corps (2),
C) séparer les contacts de connexion (4, 5) conjointement avec la base (3), la base et les contacts de connexion (4, 5) étant divisés.

12. Procédé selon la revendication 11,
dans une étape supplémentaire, une ou plusieurs parties de corps (2) étant fournies et disposées sur la base (3) .

13. Procédé selon la revendication 12,
l'étape C) de séparation étant effectuée après que les parties de corps (2) ont été disposées sur la base (3).

14. Procédé selon la revendication 12,
l'étape C) de séparation étant effectuée avant que les parties de corps (2) ne soient disposées sur la base (3) .

15. Procédé selon l'une des revendications 11 à 14,
les parties de corps (2) pouvant être fixées par serrage entre les contacts de connexion (4, 5).
